# FASCICULE DE BREVET EUROPEEN

(11) **EP 1 756 864 B1**
(45) Date de publication et mention de la délivrance du brevet: **01.08.2012**
(21) Numéro de dépôt: 05767616.5
(22) Date de dépôt: 25.04.2005
(51) Int. Cl.: H01L 21/78

(54) **PROCEDE DE FABRICATION DE PUCES**
VERFAHREN ZUR HERSTELLUNG VON CHIPS
METHOD FOR MAKING CHIPS

(30) Priorité: 27.04.2004 FR 0404437
(43) Date de publication de la demande: 28.02.2007
(73) Titulaire: Soitec, 38190 Bernin (FR)
(72) Inventeur: GHYSELEN, Bruno, F-38170 Seyssinet - Pariset (FR); RAYSSAC, Olivier, F-38100 Grenoble (FR)
(74) Mandataire: Collin, Jérôme
(86) Numéro de dépôt international: PCT/FR2005/001021
(87) Numéro de publication internationale: WO 2005/106948

(56) Documents cités:
- EP-A- 0 610 657
- EP-A- 1 160 853
- JP-A- 2001 203 174
- US-A- 5 904 548
- PATENT ABSTRACTS OF JAPAN vol. 0111, no. 19 (E-499), 14 avril 1987 (1987-04-14) -& JP 61 267342 A (FUJIKURA LTD), 26 novembre 1986 (1986-11-26)
- PATENT ABSTRACTS OF JAPAN vol. 0090, no. 27 (E-294), 6 février 1985 (1985-02-06) & JP 59 172740 A (MITSUBISHI DENKI KK), 29 septembre 1984 (1984-09-29)

## Description

La présente invention concerne de manière générale la fabrication de circuits de type électronique, optronique et/ou opto-électronique, sur des couches minces de matériau semiconducteur tels que du silicium.

Plus précisément, l'invention concerne un procédé de fabrication d'une pluralité de puces, chaque puce comportant au moins un circuit.

On précise que par « découpage on entend de manière générale l'opération consistant à séparer les puces individuelles les unes des autres.

On entend par « puce » un module comprenant un ou plusieurs circuits.

Et par « circuit », on entend tout type de circuit microélectronique, électronique, optronique et/ou opto-électronique.

On précise également que les « couches » dont il s'agit ici sont de préférence des couches minces, dont l'épaisseur peut être de l'ordre de 0,1 à 10 microns par exemple.

Et les circuits que l'on constitue ainsi sont typiquement réalisés de manière répétitive, en constituant sur une couche mince une pluralité de circuits identiques, qui permettront de constituer de manière correspondante une pluratité de puces identiques.

De manière générale, des procédés de fabrication de puces sont déjà connus.

Un premier type de procédé connu que l'on cite pour mémoire consiste ainsi à réaliser les puces directement dans la partie superficielle d'un substrat massif de matériau semiconducteur (par exemple du silicium, ou un matériau III-V).

Une fois les puces constituées, on découpe le substrat dans toute son épaisseur, pour séparer les puces les unes des autres.

Ce découpage est réalisé sous la forme d'un sciage du substrat.

Pour réaliser le sciage, on effectue généralement un premier « trait de scie », après quoi on casse dans un deuxième temps le substrat au niveau des traits de scie. Un procédé est décrit en JP-A-61267342.

Une limitation de ce type de procédé est qu'il ne permet pas d'obtenir des puces sur un substrat de faible épaisseur.

En effet, les substrats massifs à partir desquels on constitue les puces ont des épaisseurs relativement importantes (de l'ordre de la centaine de microns au moins - par exemple 725 microns pour un substrat de 200 mm de diamètre), épaisseurs qui peuvent s'avérer trop importantes pour certaines applications.

Des exemples non limitatifs de telles applications, pour lesquelles les substrats massifs sont mal adaptés, sont ainsi :
- La fabrication de puces comportant des diodes électroluminescentes, car une épaisseur trop importante du substrat sur lequel la puce est constituée peut influer sur le comportement optique des circuits - par exemple dans le cas où le substrat absorbe une partie de la lumière,
- La fabrication de puces devant présenter une certaine souplesse mécanique, des substrats de type silicium monocristallin - qui est un matériau rigide et cassant - devant alors pour conférer à la puce la souplesse requise être plus fins que les substrats massifs employés.

Il est certes possible d'amincir la face arrière d'un substrat massif tel que mentionné ci-dessus dans la couche superficielle duquel on a constitué des puces (la face arrière du substrat étant dans ce texte définie comme la face opposée à la face « avant » du substrat, qui porte les puces).

Un tel amincissement peut être réalisé par exemple par gravure chimique de la face arrière du substrat, ou par une attaque mécanique de cette face arrière.

Mais un tel amincissement du substrat est nécessairement limité, car le substrat doit conserver une certaine épaisseur (de l'ordre de 50 microns) pour garder une tenue mécanique acceptable.

Et les applications tettes que mentionnés ci-dessus, qui nécessitent la mise en oeuvre d'une fine couche dans laquelle les puces sont constituées, restent difficiles d'accès même après un tel amincissement.

Il apparaît donc que ce premier type de procédé connu est associé à des limitations.

On précise en outre que le sciage des puces peut être associé à des problèmes (du type écaillage du substrat scié), ce qui correspond à une autre limitation de ce type de procédé.

On connaît également un deuxième type de procédé pour réaliser des puces sur un substrat.

Selon ce deuxième type de procédé on procède aux étapes suivantes :
- Création des puces sur une couché de matériau semiconducteur, ladite couche étant solidaire d'un substrat,
- transfert de ladite couche comportant les puces du substrat sur un support,
- constitution de puces individuelles par le découpage de ladite couche selon un motif de découpage prédéterminé.

On précise qu'on entend par motif « prédéterminé » un motif que l'on a élaboré pour définir des lignes de découpage désirées.

Les puces sont donc constituées dans la couche de matériau semiconducteur avant le transfert de ladite couche sur le support receveur.

La couche de matériau semiconducteur peut être une couche « mince », c'est à dire d'une épaisseur de l'ordre de 0,1 à 10 microns.

Le motif prédéterminé correspond typiquement à une grille à cases carrées ou rectangulaires dont les lignes définissent les limites des puces.

Ce découpage est typiquement réalisé par sciage de la couche mince, et éventuellement dans le même temps du support dont la couche a été rendue solidaire.

Le transfert de la couche mince sur le support peut être réalisé par tout type de technique connu en soi.

Il est en particulier connu d'effectuer ce transfert par fracture d'une zone de fragilisation prévue entre la couche mince que l'on désire transférer sur le support et un substrat dont la couche mince est initialement solidaire.

Cette zone de fragilisation peut avoir été constituée avant la fabrication de puces évoquée plus haut, ou après.

Et il est également possible que seulement certaines étapes de la fabrication des puces aient été effectuées avant la constitution de la zone de fragilisation, les autres étapes permettant de fabriquer les puces étant effectuées après que l'on ait constitué la zone de fragilisation.

Cette zone de fragilisation peut être par exemple réalisée par une implantation d'une ou plusieurs espèces atomiques et/ou ioniques, comme ceci est le cas pour des techniques de type Smart-Cut^{®}.

La zone de fragilisation peut également être obtenue en contrôlant l'énergie de liaison entre deux couches dont l'interface commune définit la zone de fragilisation - on parle dans ce cas au sens large de substrats « démontables » dont on peut transférer une couche par application d'une contrainte (mécanique et/ou thermique en particulier) au niveau de l'interface de fragilisation.

Une zone de fragilisation peut ainsi être constituée par exemple en créant entre deux couches du substrat une zone poreuse, ou encore en réalisant un collage réversible entre les deux couches. D'autres méthodes sont également envisageables.

On précise également qu'il est aussi connu d'effectuer sur le support le transfert d'un substrat épais, puis d'amincir par sa face arrière le substrat transféré (techniques de type BSOI^{®} ou BESOI^{®}). On obtient ainsi une couche mince transférée sur un support.

Après le transfert de la couche mince et de ses circuits sur le support, on procède au découpage de la couche pour constituer les puces individuelles.

Ce type de procédé connu peut permettre d'obtenir des puces sur des couches ayant une épaisseur très réduite.

Il peut également permettre de constituer des puces sur un support dont le matériau, différent du matériau du substrat dans lequel les puces ont été réalisées (le matériau de la couche mince), peut avoir une nature et des propriétés spécifiques désirées.

Mais les inconvénients mentionnés ci-dessus à propos du sciage (en particulier écaillage) subsistent.

Ces inconvénients sont même renforcés dans le cas du sciage de couches d'épaisseur réduite.

Le but de l'invention est de perfectionner le deuxième type de procédé mentionné ci-dessus, notamment pour permettre de s'affranchir des inconvénients liés au sciage.

Et le but général de l'invention est d'améliorer les procédés connus mentionnés ci-dessus. On verra à cet égard que l'invention permet d'atteindre des avantages spécifiques.

Afin d'atteindre ces buts, l'invention propose conforme à la revendication 1. un procédé de fabrication d'une pluralité de puces.

Des aspects préférés, mais non limitatifs de ce procédé sont indiqués dans les revendications 2-25.

D'autres aspects, buts et avantages de l'invention apparaîtront mieux à la lecture de la description suivante, faite en référence aux dessins annexés sur desquels :
- la figure 1 est une représentation schématique d'un support pouvant être mis en oeuvre dans le cadre de l'invention,
- la figure 2a est une représentation schématique partielle de la surface d'un support pouvant être mis en oeuvre dans un mode de réalisation de l'invention,
- la figure 2b illustre une étape de fabrication possible pour réaliser un support tel que celui de la figure 2a,
- les figures 3a à 3c sont des représentations schématiques de trois étapes pouvant être mises en oeuvre dans le cadre de l'invention,
- la figure 4. illustre schématiquement la rupture d'une couche comportant des puces et du support associé, au niveau d'une ligne d'un motif de fragilisation.

On précise que ces figures sont des représentations schématiques sur lesquelles les différents éléments ne sont pas à l'échelle (notamment en ce qui concerne l'épaisseur des couches, le nombre et l'écartement des puces, etc...).

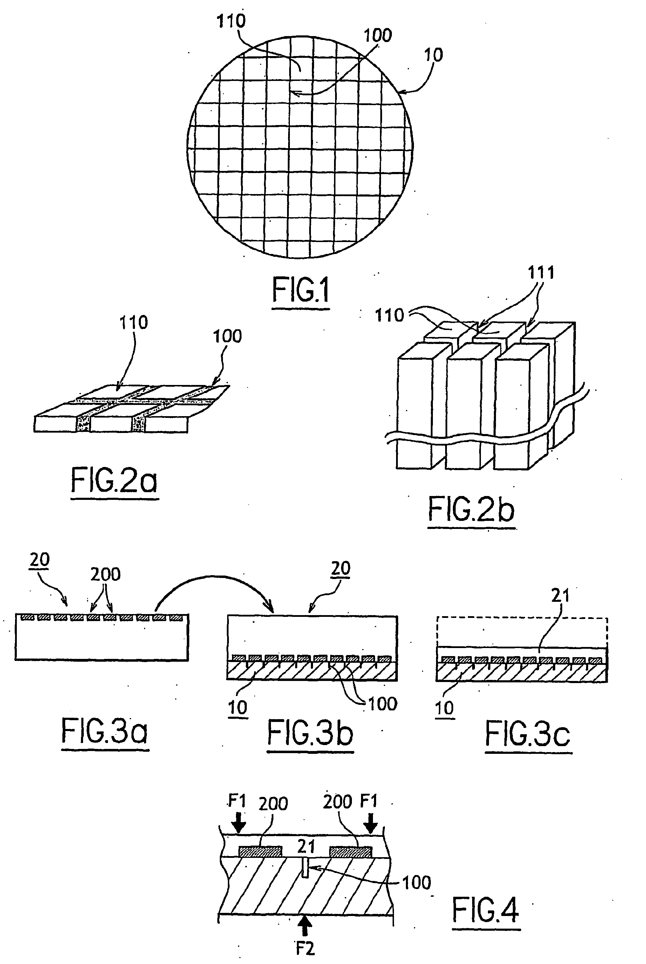

En référence à la figure 1 on a représenté schématiquement en vue de dessus un support 10 pouvant être mis en oeuvre dans le cadre de l'invention.

Le support 10 couvre une surface correspondante. à la surface d'une couche comportant des puces préconstituées, que l'on désire transférer sur ce support.

Le support 10 est réalisé en un matériau semi-conducteur tel que le silicium.

Il est également possible de réaliser le support 10 en un autre matériau, par exemple en verre, en plastique, en un polymère présentant des propriétés désirées, ou encore en métal.

On remarque sur la surface du support une pluralité de lignes 100 qui délimitent des régions 110.

Ces lignes 100 et ces régions 110 sont situées sur une même face du support (dite face fragilisée).

Il est possible en variante de prévoir des lignes du type des lignes 100, définissant des régions 110, sur les deux faces du support. Dans ce cas, les deux faces du support sont « fragilisées ». On reviendra sur cette possibilité.

Les lignes 100 correspondent à des lignes de fragilisation du support et/ou de guidage du découpage de puces, comme cela sera expliqué plus loin dans ce texte.

Les lignes 100 forment ainsi en tout état de cause un motif de fragilisation, dont le rôle va être expliqué ci-après.

Plus précisément, chaque région 110 est définie de manière à correspondre à une ou plusieurs puces d'une couche de matériau semiconducteur qui sera transférée sur le support.

Et le motif de fragilisation correspond quant à lui au motif de découpage de ces puces de la couche qui sera transférée sur le support..

Les lignes 100 peuvent avoir été constituées sur le support 10 par gravure d'un réseau de tranchées dans l'épaisseur du support.

Une telle gravure peut notamment être une gravure chimique, réalisée à l'aide d'un masque approprié ne laissant exposées que les parties du support correspondant aux lignes 100.

La gravure du support permettant de réaliser les lignes 100 peut également être une gravure de type mécanique.

Les tranchées peuvent également avoir été obtenues par un sciage partiel de l'épaisseur du support, selon le motif de découpage désiré.

On précise que la face fragilisée du support peut être la face du support destinée à être en contact avec la couche transférée sur laquelle des puces auront été préalablement constituées.

Il est également possible en variante que la face fragilisée du support soit la face opposée à la face du support devant recevoir la couche transférée.

Et il est comme on l'a dit également possible de prévoir que les deux faces du support soient associées à un motif de fragilisation. Dans ce cas, les deux motifs peuvent être différents pour définir des régions 110 de dimensions différentes et/ou disposées selon une répartition différente sur la surface du support.

On a dit que les lignes de fragilisation 100 pouvaient être des tranchées.

Ces lignes peuvent également être à l'inverse des profiles saillants hors de la surface du support 10.

Elles peuvent avoir été réalisées par gravure anisotrope du support (gravure qui permet de réaliser des tranchées dont la section transversale a une forme générale de « V » du fait de l'attaque accélérée selon certaines directions cristallographiques).

Le support peut également avoir été constitué à partir d'éléments individuels distincts qui correspondent aux régions 110.

La figure 2a illustre ainsi une partie de la surface fragilisée d'un support 10, dans lequel les régions individuelles 110 sont des pavés d'un matériau tel que ceux mentionnés ci-dessus pour constituer le support.

Les pavés 110 sont reliés entre eux par un liant qui constitue les lignes 100.

Le liant peut être par exemple une colle réversible, une cire, un polymère, ou tout liant pouvant être dissous.

La figure 2b illustre un mode de réalisation d'un support tel que représenté sur la figure 2a.

Sur cette figure, on a représenté une pluralité de lingots ou fils 111 disposés parallèlement les uns aux autres, de manière à ce que leur emplacement correspondent aux emplacements souhaités pour les régions 1.10.

La section de chaque lingot ou fil 111 correspond au contour souhaité pour la région 110 correspondante (dans le cas illustré ici, les lingots ont une section carrée).

Après avoir ainsi positionné les lingots ou fils 111, on introduit entre eux le liant qui permettra de les rendre solidaire les uns des autres.

On découpe ensuite l'ensemble formé de la sorte, selon une direction de coupe transversale à l'axe des lingots.

On constitue ainsi des « tranches » dont chacune correspond à un support du type de celui représenté schématiquement sur la figure 1.

En référence maintenant aux figures 3a à 3c, on va décrire un mode de mise en oeuvre de l'invention.

On a représenté sur la figure 3a un substrat 20, dans la région superficielle duquel on a constitué les circuits d'une pluralité de puces 200. Ces circuits ont pu être constitués simultanément, lors d'une étape préalable de constitution de puces.

Les puces sont disposées à la surface du substrat 20 selon une disposition désirée, qui correspond comme on l'a dit à la disposition de régions 110 d'un support destiné à recevoir une couche issue du substrat 20.

La couche issue du substrat 20 sera ainsi transférée sur le support,

Il peut s'agir d'une couche « fine » au sens du présent texte, c'est à dire d'une épaisseur de l'ordre de 0,1 à 10 microns.

Le substrat 20 peut être réalisé par exemple en silicium.

Après avoir constitué les puces sur le substrat, on procède à l'assemblage de ce substrat sur un support 10 dont les régions 110 sont disposées en correspondance avec les puces 200 du substrat 20.

L' « assemblage » est une mise en contact intime entre le substrat 20 et le support 10, qui assure une liaison mécanique entre ces deux éléments.

L'assemblage peut ainsi notamment être un collage.

Et on peut avoir nettoyé la surface de contact du support et/ou celle du substrat, préalablement à cet assemblage.

Dans un mode de mise en oeuvre préféré, chaque région 110 du support correspond individuellement à une puce 200 du substrat 20. Dans ce cas, lors de l'assemblage chaque puce se trouve en regard d'une région 110 du support.

Il est également possible de prévoir tout type de correspondance désiré entre les régions 110 du support, et les puces ou groupes de puces du substrat 20 (affectation de certains groupes de puces à certaines régions, etc..).

Lors de cet assemblage du substrat 20 et du support 10, la face du substrat 20 qui est mise en contact avec le support 10 est la face portant les puces 200.

On rappelle que la face fragilisée du support 10 peut quant à elle être tournée vers le substrat 20, ou lui être opposée.

On constitue ainsi une structure intermédiaire telle que représentée sur la figure 3b (sur laquelle le support 10 est représenté en traits hachurés).

Sur cette figure, on a également représenté schématiquement les lignes 100 de la face fragilisée du support (qui définissent ici des régions correspondant individuellement aux puces 200).

Comme représenté sur la figure 3c, on procède ensuite à un enlèvement de matière du substrat 20, pour ne conserver au contact du support 10 qu'une couche 21 d'épaisseur désirée.

Cette épaisseur peut être par exemple de l'ordre de 0,1 à quelques microns.

La couche 21 comprend dans son épaisseur les puces 200.

L'enlèvement de matière peut avoir été réalisé par attaque de la face arrière du substrat 20.

Cette attaque peut être une attaque chimique, et/ou mécanique.

Il est également possible d'avoir réalisé cet enlèvement de matière par détachement du substrat 20 au niveau d'une zone de fragilisation qui aura été préalablement constituée dans l'épaisseur du substrat.

Dans ce cas, la zone de fragilisation aura de préférence été constituée avant l'assemblage du support 10 et du substrat 20.

Cette zone de fragilisation peut notamment avoir été constituée par implantation dans l'épaisseur du substrat d'une ou plusieurs espèces atomiques et/ou ioniques. Dans ce mode de mise en oeuvre de l'invention, on fait ainsi intervenir un procédé de type Smart-Cut^{®}.

On précise que tout autre type de transfert avec enlèvement de matière est également envisageable (constitution d'un substrat 20 de type démontable comportant une zone de fragilisation réalisée par exemple par une région poreuse du substrat 20, ou encore par un collage d'énergie contrôlée entre deux couches du substrat 20, ou une technique de transfert de type BSOI^{®} ou BESOI^{®}...).

On précise également que dans une variante de l'invention on procède, avant l'assemblage (par exemple par collage) du substrat 20 et du support 10, à un marquage de la surface du substrat 20 qui est amenée en contact avec le support 10.

Ce « marquage correspond à une attaque superficielle du substrat 20, selon un motif qui correspond (partiellement ou en totalité) au motif prédéterminé de découpage.

Ce marquage peut être réalisé en effectuant un très léger sciage de la surface du substrat. Un tel sciage est extrêmement limité en profondeur il ne vise qu'à interrompre la continuité de la surafce du substrat en produisant de légers traits de scie.

Un tel marquage favorise encore la prévention de l'écaillage lors du découpage qui va suivre.

Il permet également d'isoler les puces lors de ce découpage, ce qui concourt à les protéger.

Après avoir de la sorte constitué une structure comportant le support 10 et la fine couche 21 comportant les puces 200, on procède au découpage desdites puces.

Pour réaliser ce découpage, il n'est pas nécessaire de procéder à un sciage de la couche 21.

Le découpage peut en effet dans le cas de l'invention être réalisé par simple rupture de la couche 21 au niveau des lignes 100 qui séparent les régions 110 (et donc les régions correspondantes de la couche 21, auxquelles sont associés les différentes puces 200 ou les différents groupes de puces - en fonction de la correspondance choisie entre les régions 110 du support et les puces ou groupes de puces).

Cette rupture peut être réalisée en exerçant simultanément des contraintes sur la couche 21, et sur le support 10 auquel la couche 21 est associée.

On peut par exemple exercer sur la couche 21 une contrainte en compression dans la même direction perpendiculaire à la surface de la couche et dans le même sens, de part et d'autre d'une ligne 100 du support (flèches F1), comme représenté schématiquement sur la figure 4.

La couche et le support peuvent dans ce cas être maintenus stables au niveau de ladite ligne 100 (flèche F2).

On exerce de la sorte une contrainte en flexion au niveau de la ligne 100.

Cette contrainte produit une rupture de la couche 21, au niveau de la ligne 100.

On précise qu'il est possible d'avoir également pratiqué des lignes de fragilisation sur la surface de la couche 21 elle-même, entre les puces 200.

Lors de la rupture, on peut:
- Soit rompre uniquement la couche 21 pour découper et séparer les différentes puces 200, les régions correspondantes du support 10 restant quant à elles solidaires entre elles,
- Soit rompre non seulement la couche 21 pour en découper les puces, mais rompre également le support lui-même et en séparer ainsi les différentes régions 110.

Dans le premier cas de figure mentionné ci-dessus, il sera avantageux de prévoir que le support présente une certaine souplesse pour pouvoir se déformer sans se casser lors de la rupture de la couche 21.

Une telle souplesse pourra être obtenue notamment par les propriétés mécaniques d'un liant entre des régions de support 110 distinctes telles que représentées sur les figures 2a et 2b. Le liant sera en effet dans ce cas choisi pour autoriser une certaine déformation entre les régions 110, tout en maintenant ces régions solidaires.

Et dans un tel cas de figure, on pourra :
- Soit séparer dans un deuxième temps les régions 110 du support, pour obtenir une pluralité de puces associées individuellement aux régions 110 selon la correspondante désirée,
- Soit séparer ensuite les puces du support, pour obtenir les puces seules, non associées à une partie de support. Cette séparation dés puces et du support pourra être effectuée par exemple par détachement de la liaison au niveau de l'interface entre la couche 21 et le support 10 (ladite liaison ayant alors été constituée pour être réversible).

Dans le deuxième cas de figure mentionné ci-dessus, il est également possible de prévoir que le support soit constitué de pavés distincts, comme cela est représenté sur la figure 2a. Le liant entre les pavés pourra dans ce cas :
- Etre cassé sous la contrainte de rupture, ou
- être éliminé lors de la rupture (par exemple par dissolution du liant).

En tout état de cause, dans ce deuxième cas de figure, le liant n'assure qu'une liaison temporaire entre les régions 110.

On obtient à l'issue de ce procédé une pluralité de puces individuelles 200 séparées (ou de groupes de puces, selon la correspondance choisie entre les puces et les régions 110 du support).

On précise qu'il est possible de sélectionner le matériau du support de manière à ce que celui-ci présente des propriétés désirées.

Il est notamment possible de prévoir que ce matériau sera optiquement transparent (support en Quartz ou en verre par exemple).

Il est également possible de sélectivement prévoir que ce matériau sera électriquement conducteur (c'est à dire présentant une résistivité typiquement inférieure à 1 Ohm.cm² - un matériau tel que le cuivre pouvant être mis en oeuvre à cet effet)ou au contraire isolant (c'est à dire présentant une résistivité typiquement supérieure à 1 Ohm.cm² - un matériau tel que le verre ou le plastique pouvant être mis en oeuvre à cet effet).

Il est également possible, de manière similaire de prévoir que ce matériau sera sélectivement thermiquement conducteur (par exemple cuivre, diamant, ...), ou isolant (par exemple, verre ou plastique ...).

On précise que dans le cas d'un matériau conducteur, on mettra typiquement en oeuvre un matériau dont la conductivité thermique est supérieure à 150 W/m.°C, valeur qui correspond à la conductivité du silicium.

## Revendications

1. Procédé de fabrication d'une pluralité de puces (200), chaque puce comportant au moins un circuit, le procédé comportant la succession des étapes suivantes :
• création des puces (200) sur une couche de matériau semiconducteur, ladite couche étant solidaire d'un substrat (20), constitution sur un support d'un motif de fragilisation (100) correspondant à un motif de découpage prédéterminé.
• assemblage du substrat (20) avec le support (10), la face du substrat portant les puces étant mise en contact avec le support,
• transfert de la couche comportant les puces du substrat sur le support par enlèvement de matière du substrat (20),
• constitution de puces individuelles par le découpage de la couche comportant les puces (21) selon le motif de découpage prédéterminé.

2. Procédé selon la revendication précédente, **caractérisé en ce que** lesdits motifs de fragilisation sont disposés sur le support de manière à définir des régions de support destinées à recevoir les puces selon une correspondance désirée.

3. Procédé selon la revendication précédente, **caractérisé en ce que** lesdits motifs de fragilisation sont disposés sur le support de manière à définir des régions de support destinées à recevoir individuellement les puces respectives.

4. Procédé selon l'une des revendications précédentes, **caractérisé en ce que** la constitution des motifs de fragilisation fait intervenir une gravure d'un réseau de tranchées dans l'épaisseur du support.

5. Procédé selon la revendication précédente, **caractérisé en ce que** la gravure est une gravure chimique.

6. Procédé selon la revendication 4, **caractérisé en ce que** la gravure est une gravure mécanique.

7. Procédé selon la revendication 4, **caractérisé en ce que** la gravure est un sciage partiel de l'épaisseur du support.

8. Procédé selon la revendication 4, **caractérisé en ce que** la gravure est une gravure anisotrope du support.

9. Procédé selon la revendication précédente, **caractérisé en ce que** ladite gravure anisotrope produit sur le support des profils en pointe.

10. Procédé selon l'une des revendications précédentes, **caractérisé en ce que** le support comprend un motif de fragilisation sur une seulement de ses faces.

11. Procédé selon la revendication précédente, **caractérisé en ce que** la face du support comprenant le motif de fragilisation est disposée du côté de la couche transférée.

12. Procédé selon la revendication 10, **caractérisé en ce que** la face du support comprenant la motif de fragilisation est disposée du côté opposé à la couche transférée.

13. Procédé selon l'une des revendications précédentes, **caractérisé en ce que** lors du découpage de la couche on découpe également le support selon le motif de fragilisation.

14. Procédé selon l'une des revendications 1 à 3, **caractérisé en ce que** le procédé comprend, préalablement au transfert de ladite couche comportant les puces, la constitution du support par assemblage de pavés individuels, les limites entre pavés individuels correspondant au motif de fragilisation.

15. Procédé selon la revendication précédente, **caractérisé en ce que** l'assemblage de pavés est réalisé par l'intermédiaire d'un liant disposé entre les pavés individuels, le liant assurant une liaison temporaire entre les pavés.

16. Procédé selon l'une des revendications précédentes, **caractérisé en ce que** le support est en plastique, en verre, en polymère ou en métal,

17. Procédé selon l'une des revendications précédentes, **caractérisé en ce que** la découpage de la couche est réalisé par rupture de la couche comportant les puces selon la motif de fragilisation.

18. Procédé selon la revendication précédente, **caractérisé en ce que** lors de ladite rupture seule ladite couche comportant les puces est rompue, le support demeurant en un seul élément unitaire.

19. Procédé selon la revendication précédente prise en combinaison avec la revendication 15, **caractérisé en ce que** en association avec le découpage de la couche comportant les puces on défait lasdites liaisons temporaires entre les pavés.

20. Procédé selon la revendication précédente, **caractérisé en ce que** les liaisons temporaires sont défaites par dissolution du liant disposé entre les pavés.

21. Procédé selon l'une des deux revendications précédentes, **caractérisé en ce que** le liant est une colle réversible, une cire, ou un polymère.

22. Procédé selon la revendication 18, **caractérisé en ce que** lors de ladite rupture ladite couche comportant les puces et le support sont rompus simultanément.

23. Procédé selon l'une des revendications précédentes, **caractérisé en ce que** les puces de la pluralité de puces sont fabriquées simultanément.

24. Procédé selon l'une des revendications précédentes, **caractérisé en ce que** ledit transfert de ladite couche du substrat sur un support est réallsé par une méthode de type Smart-Cut^{®}.

25. Procédé selon l'une des revendications 1 à 23, **caractérisé en ce que** ledit transfert de ladite couche du substrat sur un support est réalisé par une méthode de type BSOI^{®} ou BESOI^{®}.

## Claims

1. A method of fabricating a plurality of chips (200), each chip comprising at least one circuit, the method comprising the following steps in succession:
- creating chips (200) on a layer of semiconductor material, said layer being integral with a substrate (20) ;
- forming a weakening pattern (100) on a support corresponding to a predetermined cutting pattern;
- assembly of the substrate (20) with the support (10), the surface of the chip-containing substrate being in contact with the support;
- transferring the chip-containing layer of the substrate on the support by removing substrate material (20) ;
- forming individual chips by cutting the chip-containing layer (21) in accordance with the predetermined cutting pattern.

2. A method according to the preceding claim, **characterized in that** said weakening patterns are disposed on the support so as to define support regions intended to receive the chips in accordance with a desired correlation.

3. A method according to the preceding claims, **characterized in that** said weakening patterns are disposed on the support to define support regions intended to receive the respective chips individually.

4. A method according to any one of the preceding claims, **characterized in that** forming the weakening patterns involves etching a network of trenches in the thickness of the support.

5. A method according to the preceding claim, **characterized in that** the etching is chemical etching.

6. A method according to claim 4, **characterized in that** the etching is mechanical etching.

7. A method according to claim 4, **characterized in that** the etching is scribing partially through the thickness of the support.

8. A method according to claim 4, **characterized in that** the etching is anisotropic etching of the support.

9. A method according to the preceding claim, **characterized in that** said anistropic etching produces sharp edged profiles on the support.

10. A method according to any preceding claim, **characterized in that** the support includes a weakening pattern on only one of it faces.

11. A method according to the preceding claim, **characterized in that** the face of the support comprising the weakening pattern is disposed on the side facing the transferred layer.

12. A method according to claim 10, **characterized in that** the face of the support comprising the weakening pattern is disposed on the side facing away from the transferred layer.

13. A method according to any one of the preceding claims, **characterized in that** during cutting of the layer, the support is also cut in accordance with the weakening pattern.

14. A method according to any one of claims 1 to 3, **characterized in that** prior to transferring said layer including the chips, the method comprises forming the support by assembling individual tiles, with the boundaries between the individual tiles corresponding to the weakening pattern.

15. A method according to the preceding claim, **characterized in that** the tiles are assembled using a binder disposed between the individual tiles, the binder ensuring temporary bonding between the tiles.

16. A method according to any one of the preceding claims, **characterized in that** the support is formed from plastic, glass, polymer, or a metal.

17. A method according to any one of the preceding claims, **characterized in that** the layer is cut by rupturing the layer including the chips in accordance with the weakening pattern.

18. A method according to the preceding claim, **characterized in that** during said rupture, only said layer including the chips is broken, the support remaining as a single unitary element.

19. A method according to the preceding claim in combination with claim 15, **characterized in that** said temporary bonds between the tiles are undone in association with cutting the layer including the chips.

20. A method according to the preceding claim, **characterized in that** the temporary bonds are undone by dissolving the binder disposed between the tiles.

21. A method according to any one of the two preceding claims, **characterized in that** the binder is a reversible adhesive, a wax, or a polymer.

22. A method according to claim 18, **characterized in that** during said rupture, the support and said layer including the chips are broken simultaneously.

23. A method according to any one of the preceding claims, **characterized in that** the chips in the plurality of chips are fabricated simultaneously.

24. A method according to any one of the preceding claims, **characterized in that** said transfer of said layer from the substrate to a support is carried out using a Smart-Cut@ type method.

25. A method according to any one of claims 1 to 23, **characterized in that** said transfer of said layer from the substrate to a support is carried out using a BSOI® or BESOI® type method.

## Patentansprüche

1. Verfahren zur Herstellung einer Gruppe aus mehreren Chips (200), wobei jeder Chip wenigstens eine Schaltung umfasst und wobei das Verfahren die Abfolge der folgenden Schritte umfasst:
• Herstellen der Chips (200) auf einer Halbleitermaterialschicht, wobei die Schicht fest mit einem Substrat (20) verbunden ist,
• Ausbilden eines einem vorgegebenen Aufteilungsmuster entsprechenden Schwächungsmusters (100) auf einem Träger,
• Zusammensetzen des Substrats (20) mit dem Träger (10), wobei die Seite des Substrats, die die Chips trägt, mit dem Träger in Kontakt gebracht wird,
• Übertragen der Schicht des Substrats, die die Chips enthält, auf den Träger durch Abtragen von Material des Substrats (20),
• Ausbilden einzelner Chips durch das Aufteilen der Schicht (21), die die Chips enthält, gemäß dem vorgegebenen Aufteilungsmuster.

2. Verfahren nach dem vorhergehenden Anspruch, **dadurch gekennzeichnet, dass** die Schwächungsmuster derart auf dem Träger angeordnet sind, dass sie Trägerzonen definieren, die dafür vorgesehen sind, die Chips gemäß einer gewünschten Übereinstimmung aufzunehmen.

3. Verfahren nach dem vorhergehenden Anspruch, **dadurch gekennzeichnet, dass** die Schwächungsmuster derart auf dem Träger angeordnet sind, dass sie Trägerzonen definieren, die dafür vorgesehen sind, die jeweiligen Chips einzeln aufzunehmen.

4. Verfahren nach einem der vorhergehenden Ansprüche, **dadurch gekennzeichnet, dass** die Ausbildung der Schwächungsmuster das Ätzen eines Netzes von Rillen in der Dicke des Trägers einsetzt.

5. Verfahren nach dem vorhergehenden Anspruch, **dadurch gekennzeichnet, dass** das Ätzen ein chemisches Ätzen ist.

6. Verfahren nach Anspruch 4, **dadurch gekennzeichnet, dass** das Ätzen ein mechanisches Ätzen ist.

7. Verfahren nach Anspruch 4, **dadurch gekennzeichnet, dass** das Ätzen ein teilweises Sägen durch die Dicke des Trägers ist.

8. Verfahren nach Anspruch 4, **dadurch gekennzeichnet, dass** das Ätzen ein anisotropes Ätzen des Trägers ist.

9. Verfahren nach dem vorhergehenden Anspruch, **dadurch gekennzeichnet, dass** das anisotrope Ätzen auf dem Träger spitz zulaufende Profile erzeugt.

10. Verfahren nach einem der vorhergehenden Ansprüche, **dadurch gekennzeichnet, dass** der Träger nur auf einer seiner Seiten ein Schwächungsmuster umfasst.

11. Verfahren nach dem vorhergehenden Anspruch, **dadurch gekennzeichnet, dass** die Seite des Trägers, die das Schwächungsmuster umfasst, auf der Seite der übertragenen Schicht angeordnet ist.

12. Verfahren nach Anspruch 10, **dadurch gekennzeichnet, dass** die Seite des Trägers, die das Schwächungsmuster umfasst, auf der entgegengesetzten Seite der übertragenen Schicht angeordnet ist.

13. Verfahren nach einem der vorhergehenden Ansprüche, **dadurch gekennzeichnet, dass** beim Aufteilen der Schicht auch der Träger entsprechend dem Schwächungsmuster aufgeteilt wird.

14. Verfahren nach einem der Ansprüche 1 bis 3, **dadurch gekennzeichnet, dass** das Verfahren vor dem Übertragen der Schicht, die die Chips enthält, das Ausbilden des Trägers durch das Zusammensetzen einzelner Blöcke umfasst, wobei die Grenzen zwischen den einzelnen Blöcken dem Schwächungsmuster entsprechen.

15. Verfahren nach dem vorhergehenden Anspruch, **dadurch gekennzeichnet, dass** das Zusammensetzen der Blöcke mittels eines Bindemittels ausgeführt wird, das sich zwischen den einzelnen Blöcken befindet, wobei das Bindemittel eine zeitweilige Verbindung zwischen den Blöcken sicherstellt.

16. Verfahren nach einem der vorhergehenden Ansprüche, **dadurch gekennzeichnet, dass** der Träger aus Kunststoff, Glas, einem Polymermaterial oder Metall besteht.

17. Verfahren nach einem der vorhergehenden Ansprüche, **dadurch gekennzeichnet, dass** das Aufteilen der Schicht durch Brechen der Schicht, die die Chips enthält, entlang dem Schwächungsmuster geschieht.

18. Verfahren nach dem vorhergehenden Anspruch, **dadurch gekennzeichnet, dass** beim Brechen nur die Schicht, die die Chips enthält, gebrochen wird, wobei der Träger als ein einheitliches Element verbleibt.

19. Verfahren nach dem vorhergehenden Anspruch in Kombination mit Anspruch 15, **dadurch gekennzeichnet, dass** zusammen mit dem Aufteilen der Schicht, die die Chips enthält, auch die zeitweiligen Bindungen zwischen den Blöcken aufgelöst werden.

20. Verfahren nach dem vorhergehenden Anspruch, **dadurch gekennzeichnet, dass** die zeitweiligen Bindungen durch das Auflösen des zwischen den Blöcken befindlichen Bindemittels aufgelöst werden.

21. Verfahren nach einem der beiden vorhergehenden Ansprüche, **dadurch gekennzeichnet, dass** Bindemittel ein reversibler Klebstoff, ein Wachs oder ein Polymer ist.

22. Verfahren nach Anspruch 18, **dadurch gekennzeichnet, dass** beim Brechen die Schicht, die die Chips enthält, und der Träger gleichzeitig gebrochen werden.

23. Verfahren nach einem der vorhergehenden Ansprüche, **dadurch gekennzeichnet, dass** die Chips der Gruppe aus mehreren Chips gleichzeitig hergestellt werden.

24. Verfahren nach einem der vorhergehenden Ansprüche, **dadurch gekennzeichnet, dass** das Übertragen der Schicht des Substrats auf einen Träger durch ein Verfahren vom Typ Smart-Cut^{®} ausgeführt wird.

25. Verfahren nach einem der Ansprüche 1 bis 23, **dadurch gekennzeichnet, dass** das Übertragen der Schicht des Substrats auf einen Träger durch ein Verfahren vom Typ BSOI^{®} oder BESOI^{®} ausgeführt wird.
